# EUROPÄISCHE PATENTSCHRIFT

(11) **EP 2 460 365 B1**
(45) Veröffentlichungstag und Bekanntmachung des Hinweises auf die Patenterteilung: **14.08.2013**
(21) Anmeldenummer: 10721028.8
(22) Anmeldetag: 02.06.2010
(51) Int. Cl.: H04R 19/00

(54) **BAUELEMENT MIT EINER MIKROMECHANISCHEN MIKROFONSTRUKTUR UND VERFAHREN ZUR HERSTELLUNG EINES SOLCHEN BAUELEMENTS**
ELECTRONIC COMPONENT HAVING MICROMECHANICAL MICROPHONE STRUCTUR AND METHOD FOR PRODUCTION
COMPOSANT ÉLECTRONIQUE COMPRENANT UNE MICROPHONE MICROMECHANIQUE ET PROCEDE DE FABRICATION

(30) Priorität: 31.07.2009 DE 102009028177
(43) Veröffentlichungstag der Anmeldung: 06.06.2012
(73) Patentinhaber: Robert Bosch GmbH, 70442 Stuttgart (DE)
(72) Erfinder: REINMUTH, Jochen, 72766 Reutlingen (DE)
(86) Internationale Anmeldenummer: PCT/EP2010/057709
(87) Internationale Veröffentlichungsnummer: WO 2011/012360

(56) Entgegenhaltungen:
- WO-A1-2004/106879
- DE-A1-102005 056 759
- DE-A1-102006 016 811
- GB-A- 2 436 460
- US-A1- 2003 133 588

## Beschreibung

### Stand der Technik

Die Erfindung betrifft ein Bauelement mit einer mikromechanischen Mikrofonstruktur, die in einem Schichtaufbau über einem Substrat realisiert ist. Die Mikrofonstruktur umfasst eine durch den Schalldruck auslenkbare Membran, die eine als Rückseitenvolumen fungierende Kaverne in der Bauelementrückseite überspannt, und ein feststehendes akustisch durchlässiges Gegenelement, das über der Membran angeordnet ist.

Des Weiteren betrifft die Erfindung ein Verfahren zur Herstellung eines solchen Bauelements.

MEMS(Micro-Electro-Mechanical-System)-Mikrofone, deren aktive Mikrofonstruktur in einem Schichtaufbau auf einem Substrat ausgebildet ist, sind aus der Praxis bekannt. Der Schalldruck wird hier meist in Form einer Kapazitätsänderung zwischen der akustisch aktiven Membran und dem weitgehend starren Gegenelement erfasst. Dabei hängt die Qualität des Mikrofonsignals wesentlich von der Größe und Anordnung des Rückseitenvolumens in Bezug auf die Membran ab. Wenn im Randbereich der Membran Bypassöffnungen oder auch stegartige Federelemente als Membranaufhängung ausgebildet sind, sollte sich die Anschlussöffnung zwischen Membran und Rückseitenvolumen möglichst nur über den geschlossenen Mittelbereich der Membran erstrecken, um einen akustischen Kurzschluss zu vermeiden. Andererseits hängt die Dämpfung des Mikrofonsignals wesentlich von der Größe der Anschlussöffnung und des Rückseitenvolumens ab, so dass diese eine Mindestgröße aufweisen müssen, um eine bestimmte Mikrofonempfindlichkeit zu erreichen.

Es ist bekannt, das Substrat zur Realisierung des Rückseitenvolumens in einem Rückseitenätzprozess bis auf die aktive Mikrofonstruktur durchzuätzen. Abgeschlossen wird das Rückseitenvolumen dann durch die Montage des Bauelements auf einem Träger, wie beispielsweise auf einer Leiterplatte oder in einem Gehäuse.

Aus der Schrift GB-A-2 436 460 ist zum Beispiel ein Bauelement mit mikromechanischer Mikrofonstruktur bekannt, das in einem Rückseitenätzprozeß erzeugt wurde. Das Bauelement in GB-A-2 436 460 weist außerdem eine akustisch transparente Blendenöffnung auf, über die die Membran des Mikrofons an das Rückseitenvolumen angeschlossen ist, welches sich seitlich über diese Blendenöffnung erstreckt.

Diese Variante erweist sich in mehrerlei Hinsicht als problematisch. So muss der Rückseitenätzprozess sehr genau auf die Anordnung, Dimensionierung und Ausbildung der Mikrofonstruktur auf der Vorderseite des Substrats abgestimmt werden. Die Ätzfront des Rückseitenätzprozesses sollte die geschlossene Membranfläche der Mikrofonstruktur sehr genau treffen, um eine möglichst hohe Mikrofonempfindlichkeit zu erzielen. Dies erfordert eine sehr aufwendige und präzise Justierung der rückseitigen Ätzmaske in Bezug auf die Mikrofonstruktur auf der Vorderseite des Substrats. Außerdem können für den Rückseitenätzprozess ausschließlich Ätzprozesse gewählt werden, die eine sehr genaue Abbildung der Ätzmaske erzeugen. Diese Prozesse haben jedoch meist eine eher geringe Ätzrate. Der bekannte Herstellungsprozess für Bauelemente der eingangs genannten Art ist deshalb relativ fehleranfällig und zeitaufwendig.

### Offenbarung der Erfindung

Mit der vorliegenden Erfindung werden Maßnahmen vorgeschlagen, durch die die akustischen Eigenschaften eines Bauelements mit einer mikromechanischen Mikrofonstruktur auf einfache Weise verbessert werden und auch das Herstellungsverfahren vereinfacht wird.

Dazu umfasst gemäß Anspruch 1 der Schichtaufbau des erfindungsgemäßen Bauelements zwischen der Membran und dem Substrat mindestens eine Einfassungsschicht, in der eine akustisch transparente Blendenöffnung ausgebildet ist. Über diese Blendenöffnung ist die Membran an das Rückseitenvolumen angeschlossen, das sich erfindungsgemäß unter der Einfassungsschicht seitlich bis über die Blendenöffnung erstreckt.

Demnach wird erfindungsgemäß vorgeschlagen, die Anschlussöffnung der aktiven Mikrofonfläche zum Rückseitenvolumen unabhängig von der Rückseitenstrukturierung des Substrats zu definieren, und zwar in Form einer Blendenöffnung in einer zusätzlichen Einfassungsschicht des Schichtaufbaus. Die Einfassungsschicht bildet zusammen mit der Blendenöffnung eine Art Einfassung für die Membranfläche und ermöglicht so die Realisierung eines Rückseitenvolumens, das groß ist im Vergleich zur aktiven Membranfläche. Das Rückseitenvolumen des erfindungsgemäßen Bauelements erstreckt sich nämlich unterhalb der Einfassungsschicht seitlich über die Blendenöffnung hinaus und kann sich so auch über die aktive Membranfläche hinaus erstrecken. Die Einfassungsschicht verhindert in diesem Fall das Auftreten eines akustischen Kurzschlusses über etwaige Öffnungen im Randbereich der Membran.

Erfindungsgemäß ist die Einfassungsschicht mit der Blendenöffnung Bestandteil des Schichtaufbaus über dem Substrat. Demnach wird die Einfassungsschicht wie auch die Mikrofonstruktur in einem Vorderseitenprozess erzeugt. Schon aufgrund der deutlich geringeren Schichtdicke lassen sich in der Einfassungsschicht wesentlich einfacher Durchgangsöffnungen mit definierter Größe und Form erzeugen als im Substrat. Außerdem lässt sich die Blendenöffnung sehr einfach präzise unterhalb der aktiven Membranfläche positionieren, da die Mikrofonstruktur direkt über der Einfassungsschicht im Schichtaufbau realisiert wird. Sowohl die Definition der Blendenöffnung als auch der Aufbau der Mikrofonstruktur erfolgt mit Hilfe von oberflächenmikromechanischen Prozessen, die gut aufeinander abgestimmt werden können.

Wie bereits erwähnt, können im Randbereich der Membran einer mikromechanischen Mikrofonstruktur Öffnungen ausgebildet sein, die als Bypassöffnungen einen Druckausgleich zwischen dem abgeschlossenem Rückseitenvolumen und der Vorderseite der akustisch aktiven Membran ermöglichen oder auch Teil einer Federaufhängung sind, durch die die Empfindlichkeit der Membran erhöht wird. In diesem Fall erstreckt sich die akustisch transparente Blendenöffnung in der Einfassungsschicht vorteilhafterweise nur über den geschlossenen Mittelbereich der Membran. Dadurch wird ein akustischer Kurzschluss im Randbereich vermieden.

Im einfachsten Fall handelt es sich bei der akustisch transparenten Blendenöffnung des erfindungsgemäßen Bauelements um eine zusammenhängende Öffnung in der Einfassungsschicht. Die Blendenöffnung kann aber auch als Gitter- oder Lochstruktur in der Einfassungsschicht ausgebildet sein. Diese Variante erweist sich insbesondere dann als vorteilhaft, wenn die Membran als auslenkbare Elektrode fungiert, das feststehende akustisch durchlässige Gegenelement mindestens eine Gegenelektrode umfasst und Mittel zum Anlegen einer Ladespannung zwischen der Membran und der Gegenelektrode vorgesehen sind. In diesem Fall kann die Gitter- oder Lochstruktur in der Einfassungsschicht nämlich als Kompensationselektrode genutzt werden.

Mit Hilfe einer Kompensationsspannung, die zwischen der Gegenelektrode und der Kompensationselektrode angelegt wird, lässt sich die Mikrofonfunktion des erfindungsgemäßen Bauelements auf zwei messtechnisch unterschiedliche Arten realisieren, die beide eine hohe Messempfindlichkeit und eine geringe Störanfälligkeit gewährleisten.

Als Beispiel und nicht zur Erfindung gehörend wird in einer ersten Betriebsvariante die Kompensationsspannung zwischen der Gegenelektrode und der Kompensationselektrode in Abhängigkeit von der Ladespannung der Messkapazität gewählt, und zwar so, dass die durch die Ladespannung erzeugte elektrische Anziehung zwischen der Membran und der Gegenelektrode durch die Kompensationsspannung ausgeglichen wird. Dadurch befindet sich die bewegliche Membran in einem nahezu potentialfreien Raum, wo keine elektrostatischen Kräfte auf die Membran wirken und Membranauslenkungen allein durch den Schalldruck verursacht werden. Deshalb kann die Ladespannung für die Messkapazität hier auch bei kleinem Elektrodenabstand relativ hoch angesetzt werden, um ein hohes Messsignal in Form der Spannungsänderung zwischen Membran und Gegenelektrode zu erhalten. Ein elektrostatisch bedingter Kollaps der Mikrofonstruktur ist dabei nicht zu befürchten.

Im Unterschied dazu wird die Kompensationsspannung bei einer zweiten beispielhaften Betriebsvariante, so geregelt, dass die bewegliche Membran auch bei Schalleinwirkungen möglichst in ihrer Ruhelage gehalten wird. In diesem Fall wird die Spannung zwischen der Gegenelektrode und der Membran, die sich aufgrund des Schalldrucks mit dem Elektrodenabstand ändert, als Stellgröße für die Regelung der Kompensationsspannung verwendet. Als Mikrofonsignal dient hier die Kompensationsspannung. Auch bei dieser Variante kann mit relativ hohen Ladespannungen bei vergleichsweise geringem Elektrodenabstand gearbeitet werden. Zudem erweist sie sich als besonders unempfindlich gegenüber elektromagnetischen Störsignalen.

Wie bereits erwähnt, wird die Einfassungsschicht wie auch die Mikrofonstruktur des erfindungsgemäßen Bauelements in einem Vorderseitenprozess gemäß Anspruch 8 erzeugt. Auch die Definition der Blendenöffnung in der Einfassungsschicht erfolgt erfindungsgemäß von der Vorderseite des Schichtaufbaus ausgehend. Deshalb können Lage, Form und Größe der Blendenöffnung sehr genau vorgegeben werden. Da die Blendenöffnung nicht durch den Rückseitenätzprozess definiert wird, ist die Justierung des Rückseitenätzprozesses bezüglich der akustisch aktiven Membranfläche vergleichsweise unkritisch. Für die Strukturierung der Rückseite können nun auch Prozesse mit einer relativ geringen Abbildungsgenauigkeit verwendet werden, die sich aber durch eine hohe Ätzrate auszeichnen. Auch stark streuende Ätzprozesse, die Ausnehmungen mit negativer Flankensteilheit erzeugen, können zum Einsatz kommen. Dadurch kann der Rückseitenätzprozess deutlich verkürzt werden. Außerdem können dickere Wafer als Bauelementsubstrat verwendet werden, um das erforderliche Rückseitenvolumen zu erzeugen. Dies trägt wesentlich zur Miniaturisierung der Mikrofonbauelemente bei.

Für die Definition der Blendenöffnung in der Einfassungsschicht werden zwei unterschiedliche Verfahrensvarianten vorgeschlagen.

Gemäß der einen beanspruchten Verfahrensvariante wird eine erste elektrisch isolierende Opferschicht auf die Vorderseite des Ausgangssubstrats aufgebracht und strukturiert, wobei die Lage, Geometrie und Abmessungen einer Blendenöffnung in einer nachfolgend über der ersten Opferschicht erzeugten Einfassungsschicht definiert werden. Auf die so strukturierte erste Opferschicht wird dann die Einfassungsschicht aufgebracht. Darüber wird der Teil des Schichtaufbaus realisiert, in dem die Membran und das feststehende akustisch durchlässige Gegenelement der Mikrofonstruktur ausgebildet werden. Zur Realisierung des Rückseitenvolumens wird in einem nachfolgenden Rückseitenätzprozess eine Kaverne in die Rückseite des Substrats eingebracht. Dabei wird das Substrat in voller Dicke bis zur ersten Opferschicht durchgeätzt. Im Bereich der Blendenöffnung, der nicht durch die erste Opferschicht geschützt ist, wird auch die Einfassungsschicht durchgeätzt. Erst danach wird die eigentliche Mikrofonstruktur durch Opferschichtätzen freigelegt.

Diese Verfahrensvariante wird vorteilhafterweise dann angewandt, wenn die letzte Ätzphase des Rückseitenätzprozesses anisotrop verläuft. Dadurch wird gewährleistet, dass die in der ersten Opferschicht definierte Blendenöffnung sauber auf die Einfassungsschicht übertragen wird, auch wenn die Einfassungsschicht relativ dick ist. Die Strukturierung der Einfassungsschicht verursacht keine zusätzliche Topographie auf der Vorderseite des Schichtaufbaus, da die Einfassungsschicht hier ja im Rückseitenätzprozess strukturiert wird.

Auch gemäß der anderen beanspruchten Verfahrensvariante wird eine erste elektrisch isolierende Opferschicht auf die Substratoberfläche aufgebracht. Diese erste Opferschicht wird allerdings nicht im Bereich der Blendenöffnung strukturiert. Statt dessen wird die Einfassungsschicht strukturiert, die auf die erste Opferschicht aufgebracht wird. Dabei wird eine Blendenöffnung mit definierter Lage, Geometrie und definierten Abmessungen erzeugt. Darüber wird wieder der Teil des Schichtaufbaus realisiert, in dem die Membran und das feststehende akustisch durchlässige Gegenelements ausgebildet werden. Anschließend wird eine Kaverne in die Rückseite des Substrats eingebracht, wobei die erste Opferschicht als Ätzstoppgrenze fungiert. Die Blendenöffnung in der Einfassungsschicht wird hier erst zusammen mit der Mikrofonstruktur durch Opferschichtätzen freigelegt.

Diese Verfahrensvariante wird vorteilhafterweise dann angewendet, wenn besonders große Rückseitenvolumen erzeugt werden sollen. Aufgrund der im Bereich der Blendenöffnung geschlossenen ersten Opferschicht und der bereits strukturierten Blendenöffnung in der Einfassungsschicht können nämlich für die Rückseitenprozessierung auch isotrope Ätzverfahren eingesetzt werden.

In einer besonders vorteilhaften Verfahrensvariante wird die Kaverne durch Kombination eines anisotropen und eines anschließenden isotropen Ätzschritts in die Rückseite des Substrats eingebracht. Dabei wird die Substratrückseite unterhöhlt und es verbleibt eine relativ große Rückseitenfläche für die Montage des Bauelements.

### Kurze Beschreibung der Zeichnungen

Wie bereits voranstehend erörtert, gibt es verschiedene Möglichkeiten, die Lehre der vorliegenden Erfindung in vorteilhafter Weise auszugestalten und weiterzubilden. Dazu wird einerseits auf die den unabhängigen Patentansprüchen nachgeordneten Patentansprüche verwiesen und andererseits auf die nachfolgende Beschreibung zweier Ausführungsbeispiele der Erfindung anhand der Figuren.
- Fig. 1: zeigt eine schematische Schnittdarstellung eines erfindungsgemäßen Bauelements 10 mit einer mikromechanischen Mikrofonstruktur,
- Fig. 2a bis 2d: veranschaulichen die einzelnen Verfahrensschritte zur Herstellung des Bauelements 10 anhand von schematischen Schnittdarstellungen, und
- Fig. 3: zeigt eine schematische Schnittdarstellung des Schichtaufbaus 30 eines weiteren erfindungsgemäßen Bauelements vor dem Freilegen der mikromechanischen Mikrofonstruktur.

### Ausführungsformen der Erfindung

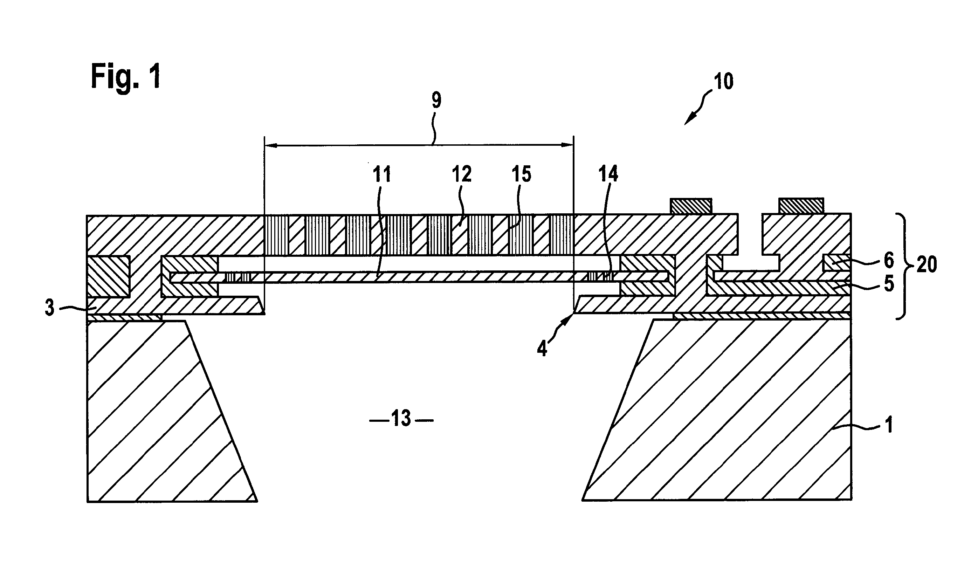

Das in **Fig. 1** dargestellte Bauelement 10 umfasst eine mikromechanische Mikrofonstruktur, die in einem Schichtaufbau 20 über einem Substrat 1 ausgebildet ist. Diese Mikrofonstruktur besteht im Wesentlichen aus einer durch den Schalldruck auslenkbaren Membran 11 und einem feststehenden akustisch durchlässigen Gegenelement 12, das über der Membran 11 angeordnet ist. Die Membran 11 überspannt eine Kaverne 13, die in der Bauelementrückseite ausgebildet ist.

Erfindungsgemäß umfasst der Schichtaufbau 20 zwischen der Membran 11 und dem Substrat 1 eine Einfassungsschicht 3, in der eine akustisch transparente Blendenöffnung 4 ausgebildet ist. Im hier dargestellten Ausführungsbeispiel ist die Blendenöffnung 4 in Form einer zusammenhängenden Öffnung in der Einfassungsschicht 3 realisiert. Die Membran 11 ist über diese Blendenöffnung 4 an die Kaverne 13 angeschlossen, die das Rückseitenvolumen für die Mikrofonstruktur bildet. Die Lage, Form und Größe der Blendenöffnung 4 sind hier genau auf die Position und Geometrie des akustisch aktiven Bereichs der Membran 11 abgestimmt, was durch den Doppelpfeil 9 angedeutet wird. Im Unterschied dazu erstreckt sich das Rückseitenvolumen unter der Einfassungsschicht 3 seitlich bis über die Blendenöffnung 4 hinaus - und damit auch über den akustisch aktiven Bereich der Membran 11 hinaus.

Im Randbereich der Membran 11 befinden sich Bypassöffnungen 14, über die ein Druckausgleich zwischen dem Rückseitenvolumen 13 und der Vorderseite der Membran 11 erfolgt. Die Bypassöffnungen 14 können beispielsweise als Zwischenräume zwischen den Federelementen einer Membranaufhängung realisiert sein. Um einen akustischen Kurzschluss über diese Bypassöffnungen 14 zu vermeiden, erstreckt sich die Blendenöffnung 4 in der Einfassungsschicht 3 lediglich über den akustisch aktiven, geschlossenen Mittelbereich der Membran 11.

Das Gegenelement 12 ist im hier dargestellten Ausführungsbeispiel deutlich dicker als die Membran 11 und damit im Wesentlichen starr. Außerdem weist das Gegenelement 12 eine Gitterstruktur mit Durchgangsöffnungen 15 auf, so dass es über dem geschlossenen Mittelbereich der Membran 11 akustisch durchlässig ist.

Die Membran 11 ist über Isolationsschichten 5 und 6 einerseits gegen die Einfassungsschicht 3 und andererseits gegen das Gegenelemente 12 elektrisch isoliert. Sowohl die Membranen 11 als auch das Gegenelement 12 bestehen zumindest bereichsweise aus einem elektrisch leitfähigen Material, wie z.B. einem entsprechend dotierten Polysilizium. Das Gegenelement 12, das im Schichtaufbau über der Membran 11 angeordnet ist, umfasst hier eine Gegenelektrode für die Membran 11, die als auslenkbare Elektrode fungiert. Zusammen bilden sie eine Messkapazität, die mit Hilfe von hier nicht dargestellten Mitteln zum Anlegen einer Ladespannung aufgeladen wird. So können Auslenkungen der Membran 11 als Kapazitätsänderungen bzw. Schwankungen einer an der Messkapazität abgegriffenen Spannung erfasst werden.

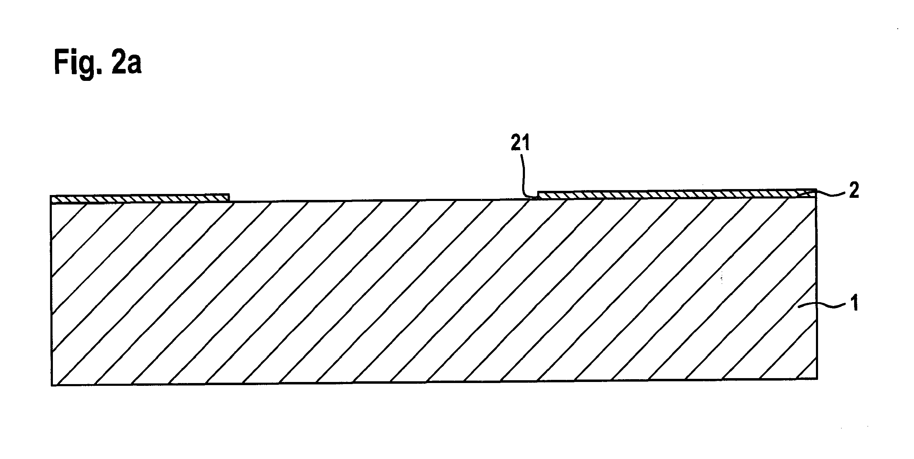

Die Herstellung des in Fig. 1 dargestellten Bauelements 10 wird nachfolgend anhand der **Figuren 2a bis 2d** erläutert.

Das Herstellungsverfahren geht von einem Substrat 1 aus, wie z.B. einem Siliziumwafer, auf dem zunächst eine erste Opferschicht 2 abgeschieden und strukturiert wird. Dabei wird eine Öffnung 21 in der Opferschicht 2 erzeugt, deren Lage, Form und Größe der Blendenöffnung in der nachfolgend aufzubringenden Einfassungsschicht entspricht. Das Substrat 1 mit der strukturierten Opferschicht 2 ist in **Fig. 2a** dargestellt. Typischerweise handelt es sich bei dem Opferschichtmaterial der ersten wie auch der weiteren Opferschichten um ein thermisches Oxid oder ein TEOS-Oxid, das im Rahmen des Bauelements 10 auch eine elektrische Isolation für einzelne Schichtbereiche bildet.

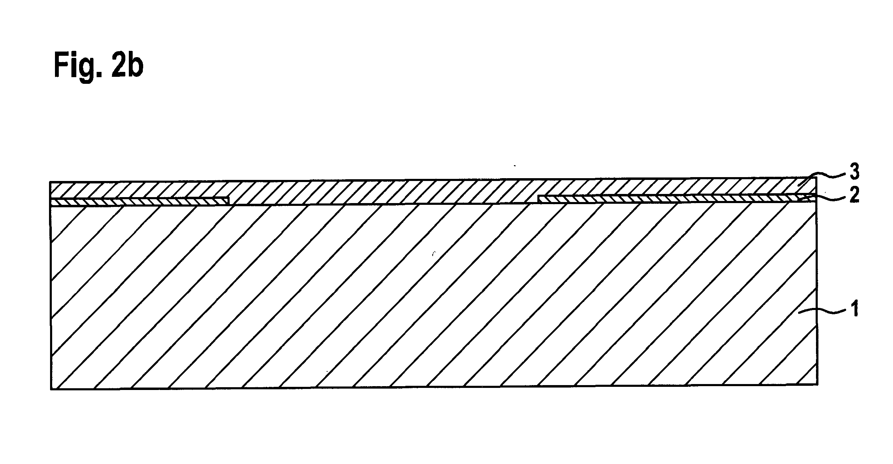

**Fig. 2b** zeigt den Schichtaufbau nach dem Aufbringen der Einfassungsschicht 3, die im Bereich der Öffnung 21 direkt auf der Substratoberfläche aufgewachsen ist. Bei der Einfassungsschicht 3 handelt es sich um eine Polysilizium- oder Epi-Polysiliziumschicht, die typischerweise signifikant dünner ist als das Substrat 1.

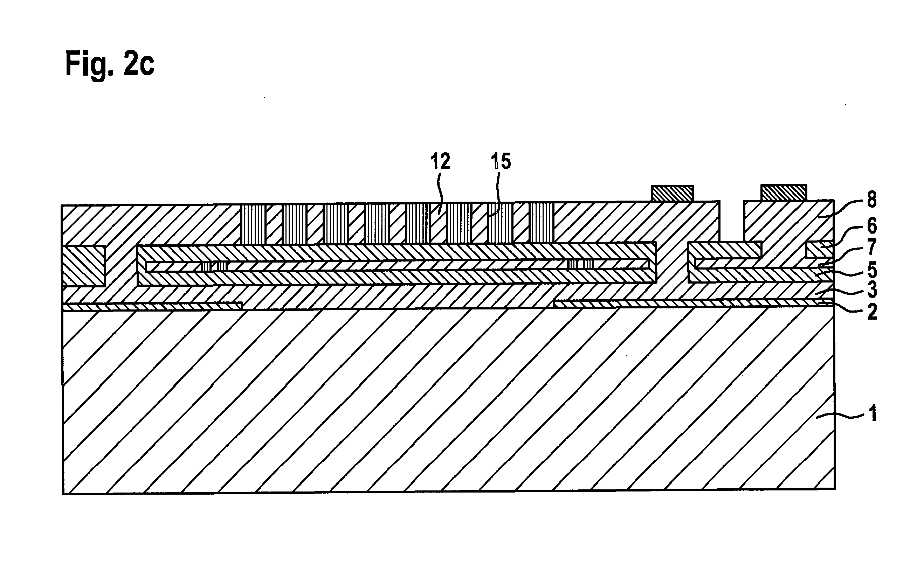

Über der Einfassungsschicht 3 werden nun die Schichten der Mikrofonstruktur erzeugt und strukturiert. Dazu wird zunächst eine zweite elektrisch isolierende Opferschicht 5 auf die Einfassungsschicht 3 aufgebracht und strukturiert, über der dann eine zumindest bereichsweise elektrisch leitfähige Membranschicht 7 erzeugt und strukturiert wird. Bei der Membranschicht 7 kann es sich beispielsweise um eine dotierte Polysiliziumschicht handeln, in der eine Federaufhängung für die Membran 11 realisiert wird, um Membranauslenkungen zu begünstigen und so die Mikrofonempfindlichkeit zu steigern. Auf die Membranschicht 7 wird eine dritte Opferschicht 6 aufgebracht und strukturiert. Die dritte Opferschicht 6 stellt zum einen die elektrische Isolation der Membranschicht 7 gegenüber einer nachfolgend auf die dritte Opferschicht 6 aufgebrachten dicken leitfähigen Schicht 8 sicher, bei der es sich beispielsweise um eine dicke Epi-Polysiliziumschicht handelt. Zum anderen definiert die dritte Opferschicht 6 den Abstand zwischen Membran 11 und Gegenelement 12, das in einem Vorderseiten-Trenchprozess aus der dicken leitfähigen Schicht 8 herausgebildet und mit Durchgangsöffnungen 15 versehen wird. Dabei fungiert die dritte Opferschicht 6 als Stoppschicht. Das Ergebnis dieser Prozessfolge ist in **Fig. 2c** dargestellt.

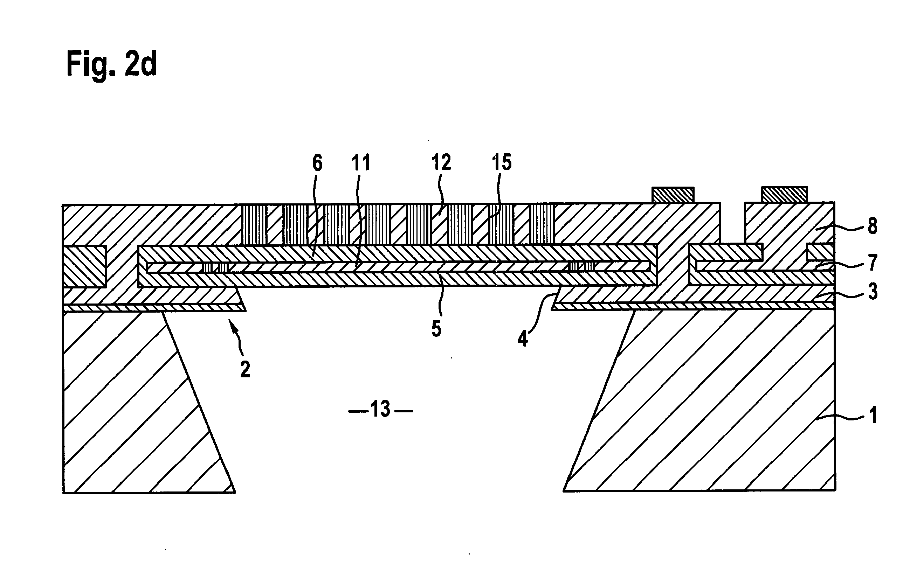

Erst danach wird eine Kaverne 13 in die Rückseite des Substrats 1 eingebracht, was durch **Fig. 2d** veranschaulicht wird. Dazu wurde im hier beschriebenen Ausführungsbeispiel ein vorwiegend anisotroper Ätzprozess verwendet, der eine Ausnehmung mit negativer Flankensteilheit erzeugt. In diesem Ätzprozesses wurde das Substratmaterial im Bereich unterhalb des geschlossenen Mittelbereichs der Membran 11 entfernt sowie das unmittelbar daran angrenzende Material der Einfassungsschicht 3, wodurch die Blendenöffnung 4 entstanden ist. Die erste Opferschicht 2 fungiert im Randbereich der Kaverne 13 als Ätzstoppschicht so wie die zweite Opferschicht 5 im Bereich der Blendenöffnung 4.

Schließlich wird noch das Material der zweiten und dritten Opferschicht 5, 6 im Membranbereich entfernt, um die Membran 11 in der Membranschicht 7 zwischen dem Gegenelement 12 in der leitfähigen Schicht 8 und der Blendenöffnung 4 in der Einfassungsschicht 3 freizulegen. Als Ergebnis dieses Opferschichtätzens erhält man dann ein Bauelement 10, wie es in Fig. 1 dargestellt ist.

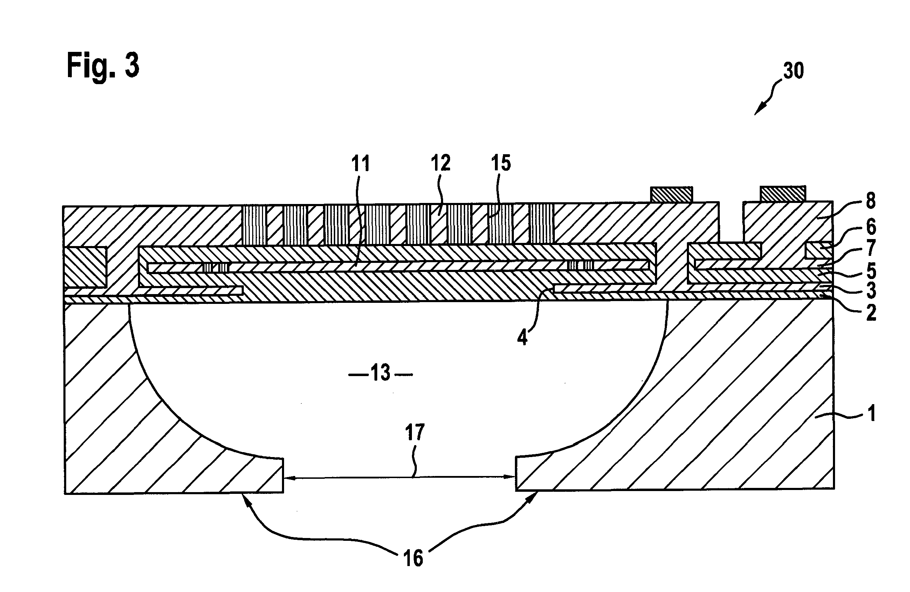

Der in **Fig. 3** dargestellte Schichtaufbau 30 veranschaulicht eine Herstellungsvariante, die ebenfalls von einem Substrat 1 ausgeht. Auch hier wird zunächst eine erste Opferschicht 2 auf die Substratoberfläche aufgebracht. Diese Opferschicht 2 wird - im Unterschied zu der in Verbindung mit den Figuren 2a bis 2d beschriebenen Verfahrensvariante - nicht strukturiert. Über der ersten Opferschicht 2 wird dann eine Einfassungsschicht 3 abgeschieden und strukturiert, wobei eine Blendenöffnung 4 mit wohl definierter Lage, Form und Größe erzeugt wird.

Wie bei der Verfahrensvariante gemäß den Figuren 2a bis 2d werden nun über der strukturierten Einfassungsschicht 3 die Schichten der Mikrofonstruktur erzeugt und strukturiert. Dazu wird zunächst eine zweite elektrisch isolierende Opferschicht 5 auf die Einfassungsschicht 3 aufgebracht und strukturiert, wobei die Blendenöffnung 4 in Opferschichtmaterial eingebettet wird. Über der zweiten Opferschicht 2 wird dann eine zumindest bereichsweise elektrisch leitfähige Membranschicht 7 erzeugt und strukturiert. Der akustisch aktive Mittelbereich der dabei ausgebildeten Membran 11 ist genau über der Blendenöffnung 4 in der Einfassungsschicht 3 angeordnet. Auf die Membranschicht 7 wird nun eine dritte Opferschicht 6 aufgebracht und strukturiert, auf die dann eine dicke leitfähige Schicht 8 aufgewachsen wird. Aus dieser Schicht 8 wird in einem Vorderseiten-Trenchprozess das Gegenelement 12 mit Durchgangsöffnungen 15 herausgebildet.

Erst danach wird eine Kaverne 13 in die Rückseite 16 des Substrats 1 eingebracht, indem das Substratmaterial bis zur ersten Opferschicht 2 entfernt wird. Im hier beschriebenen Ausführungsbeispiel wurde die Substratrückseite 16 dazu in einem anisotroper Ätzprozess geöffnet. Dabei ist die rückseitige relativ kleine Öffnung 17 der Kaverne 13 entstanden. Die Rückseitenprozessierung wurde dann mit einem isotropen Ätzprozess fortgesetzt, mit dem die Substratrückseite 16 und auch die Ränder der Blendenöffnung 4 in der Einfassungsschicht 3 unterätzt wurden, so dass das Kavernenvolumen groß ist im Vergleich zur rückseitigen Öffnung 17 und auch im Vergleich zur Blendenöffnung 4. Fig. 3 zeigt die Bauelementstruktur vor dem Freilegen der Membran 11 und der Blendenöffnung 4 in einem Opferschichtätzprozess, bei dem das Material der ersten, zweiten und dritten Opferschicht 2, 5 und 6 im Membranbereich entfernt wird.

Die in Verbindung mit Fig. 3 beschriebene Verfahrensvariante erlaubt die Herstellung von besonders kleinen Bauelementen, die aufgrund der seitlichen Unterätzung der Blendenöffnung in der Einfassungsschicht ein relativ großes Rückseitenvolumen aufweisen. Diese Bauelemente verfügen außerdem aufgrund der seitlichen Unterätzung der Substratrückseite über eine vergleichsweise große Montagefläche zur Fixierung des Bauelements auf einem Träger oder in einem Gehäuse.

## Patentansprüche

1. Bauelement (10) mit einer mikromechanischen Mikrofonstruktur, die in einem Schichtaufbau (20) über einem Substrat (1) realisiert ist, wobei die Mikrofonstruktur mindestens umfasst
- eine durch den Schalldruck auslenkbare Membran (11), die eine als Rückseitenvolumen fungierende Kaverne (13) in der Rückseite des Substrats (S.5. Zeilen 28/29) überspannt, und
- ein feststehendes akustisch durchlässiges Gegenelement (12), das über der Membran (11) angeordnet ist;
**wobei**
- der Schichtaufbau (20) zwischen der Membran (11) und dem Substrat (1) mindestens eine Einfassungsschicht (3) umfasst, und
- in dieser Einfassungsschicht (3) eine akustisch transparente Blendenöffnung (4) ausgebildet ist, über die die Membran (11) an das Rückseitenvolumen (13) angeschlossen ist, und
- sich das Rückseitenvolumen (13) unter der Einfassungsschicht (3) seitlich bis über diese Blendenöffnung (4) hinaus erstreckt,
**dadurch gekennzeichnet**
**daß** sich unter den Rändern der Einfassungsschicht (3), die die Blendenöffnung (4) definieren, eine seitliche Unterätzung befindet, durch die sich das
Rückseitenvolumen (13) seitlich über die aktive Membranfläche hinaus erstreckt.

2. Bauelement (10) nach Anspruch 1, **dadurch gekennzeichnet, dass** die Substratrückseite (16) unterätzt ist (Seite 6, Zeile 26 bis 28, Seite 10, Zeile 36 bis Seite 11, Zeile 4 sowie Zeilen 12 bis 15).

3. Bauelement (10) nach Anspruch 1 oder 2, **dadurch gekennzeichnet, dass** die Membran (11) zwischen Gegenelement (12) und Blendenöffnung (4) vorgesehen ist, wobei die Membran gegenüber dem Gegenelement und der die Blendenöffnung enthaltende Einfassungsschicht (3) elektrisch isoliert ist.

4. Bauelement (10) nach einem der vorhergehenden Ansprüche, **dadurch gekennzeichnet, dass** im Randbereich der Membran (11) eine Membranaufhängung und/oder Bypassöffnungen (14) ausgebildet sind und dass sich die akustisch transparente Blendenöffnung (4) in der Einfassungsschicht (3) nur über den geschlossenen Mittelbereich der Membran (11) erstreckt.

5. Bauelement (10) nach einem der der vorhergehenden Ansprüche, **dadurch gekennzeichnet, dass** die akustisch transparente Blendenöffnung (4) als zusammenhängende Öffnung in der Einfassungsschicht (3) ausgebildet ist.

6. Bauelement nach einem der Ansprüche 1 bis 4, **dadurch gekennzeichnet, dass** die akustisch transparente Blendenöffnung als Gitter- oder Lochstruktur in der Einfassungsschicht ausgebildet ist.

7. Bauelement nach Anspruch 6, wobei die Membran als auslenkbare Elektrode fungiert, das feststehende akustisch durchlässige Gegenelement mindestens eine Gegenelektrode umfasst und Mittel zum Anlegen einer Ladespannung zwischen der Membran und der Gegenelektrode vorgesehen sind,
**dadurch gekennzeichnet, dass** die Gitter- oder Lochstruktur in der Einfassungsschicht als Kompensationselektrode fungiert und dass Mittel zum Anlegen einer Kompensationsspannung zwischen der Gegenelektrode und der Kompensationselektrode vorgesehen sind.

8. Verfahren zur Herstellung eines Bauelements mit einer mikromechanischen Mikrofonstruktur, insbesondere zur Herstellung eines Bauelements (10) nach einem der Ansprüche 1 bis 7, bei dem eine Membran (11) und ein feststehendes akustisch durchlässiges Gegenelement (12) im Schichtaufbau (20) über einem Substrat (1) realisiert werden,
**wobei**
- in einem Vorderseitenprozess Lage, Form und Abmessungen einer akustisch transparenten Blendenöffnung (4) in einer Einfassungsschicht (3) zwischen der Substratoberfläche und der Membranschicht (7) definiert werden, und
- die Membran (11) und das Gegenelement (12) im Schichtaufbau (20) über der Einfassungsschicht (3) ausgebildet werden, und
- eine Kaverne (13) in die Rückseite des Substrats (1) eingebracht wird und durch Freilegen der Blendenöffnung (4) in der Einfassungsschicht (3) an die Mikrofonstruktur angeschlossen wird,
**dadurch gekennzeichnet dass**
die Blendenöffnung (4) seitlich unter den Rändern der Einfassungsschicht (3), die die Blendenöffnung (4) definieren, unterätzt wird, so dass sich das Rückseitenvolumen (13) seitlich über die aktive Membranfläche hinaus erstreckt.

9. Verfahren nach Anspruch 8, **dadurch gekennzeichnet, dass** zum Einbringen der Kaverne (13) die Substratrückseite (16) unterätzt wird (Seite 6, Zeile 26 bis 28, Seite 10, Zeile 36 bis Seite 11, Zeile 4 sowie Zeilen 12 bis 15).

10. Verfahren nach Anspruch 8 oder 9, bei dem
- auf die Substratoberfläche mindestens eine erste elektrisch isolierende Opferschicht (2) aufgebracht und strukturiert wird, wobei die Lage, Geometrie und Abmessungen der Blendenöffnung (4) in mindestens einer nachfolgend über der ersten Opferschicht (2) erzeugten Einfassungsschicht (3) definiert werden,
- auf der strukturierten ersten Opferschicht (2) die mindestens eine Eirifassungsschicht (3) erzeugt wird,
- auf der Einfassungsschicht (3) mindestens eine zweite elektrisch isolierende Opferschicht (5) aufgebracht und strukturiert wird,
- über der zweiten Opferschicht (5) eine zumindest bereichsweise elektrisch leitfähige Membranschicht (7) erzeugt und strukturiert wird,
- über der Membranschicht (7) mindestens eine dritte elektrisch isolierende Opferschicht (6) aufgebracht und strukturiert wird,
- über der dritten Opferschicht (6) eine zumindest bereichsweise elektrisch leitfähige Schicht (8) zur Realisierung des feststehenden Gegenelements (12) erzeugt wird,
- diese leitfähige Schicht (8) in einem Vorderseiten-Trenchprozess strukturiert wird, wobei die dritte Opferschicht (6) als Stoppschicht dient,
- zur Realisierung eines Rückseitenvolumens eine Kaverne (13) in die Rückseite des Substrats (1) eingebracht wird, wobei die erste Opferschicht (2) im Randbereich der Kaverne (13) und die zweite Opferschicht (5) im Bereich der Blendenöffnung (4) als Stoppschichten fungieren, und
- zumindest die zweite und die dritte Opferschicht (5, 6) im Membranbereich entfernt werden, um die Membran (11) in der Membranschicht (7) zwischen dem Gegenelement (12) in der leitfähigen Schicht (8) und der Blendenöffnung (4) in der Einfassungsschicht (3) freizulegen.

11. Verfahren nach Anspruch 8 oder 9, bei dem
- auf die Substratoberfläche mindestens eine erste elektrisch isolierende Opferschicht (2) aufgebracht wird,
- auf der ersten Opferschicht (2) die mindestens eine Einfassungsschicht (3) erzeugt und strukturiert wird, wobei die Blendenöffnung (4) mit definierter Lage, Geometrie und definierten Abmessungen erzeugt wird,
- auf der Einfassungsschicht (3) mindestens eine zweite elektrisch isolierende Opferschicht (5) aufgebracht und strukturiert wird,
- über der zweiten Opferschicht (5) eine zumindest bereichsweise elektrisch leitfähige Membranschicht (7) erzeugt und strukturiert wird,
- über der Membranschicht (7) mindestens eine dritte elektrisch isolierende Opferschicht (6) aufgebracht und strukturiert wird,
- über der dritten Opferschicht (6) eine zumindest bereichsweise elektrisch leitfähige Schicht (8) zur Realisierung des feststehenden Gegenelements (12) erzeugt wird,
- diese leitfähige Schicht (8) in einem Vorderseiten-Trenchprozess strukturiert wird, wobei die dritte Opferschicht (6) als Stoppschicht dient,
- zur Realisierung eines Rückseitenvolumens eine Kaverne (13) in die Rückseite des Substrats (1) eingebracht wird, wobei die erste Opferschicht (2) als Ätzstoppgrenze fungiert,
- die erste, zweite und die dritte Opferschicht (2, 5, 6) im Membranbereich und im Bereich der Blendenöffnung (4) entfernt werden, um die Membran (11) in der Membranschicht (7) zwischen dem Gegenelement (12) in der leitfähigen Schicht (8) und der Blendenöffnung (4) in der Einfassungsschicht (3) freizulegen.

12. Verfahren nach einem der Ansprüche 8 bis 11, **dadurch gekennzeichnet, dass** die Kaverne durch Kombination eines anisotropen und eines anschließenden isotropen Ätzschritts in die Rückseite des Substrats eingebracht wird.

13. Verfahren nach einem der Ansprüche 8 bis 12, **dadurch gekennzeichnet, dass** als Substrat ein Siliziumsubstrat verwendet wird, dass die erste Opferschicht aus einem thermischen Oxid oder einem TEOS-Oxid gebildet wird und dass als Einfassungsschicht eine Polysiliziumschicht oder eine Epi-Polysiliziumschicht verwendet wird.

## Claims

1. Component (10) having a micromechanical microphone structure realized in a layer construction (20) above a substrate (1), wherein the microphone structure at least comprises
- a membrane (11), which can be deflected by sound pressure and spans a cavity (13) functioning as a rear-side volume in the rear side of the substrate (page 5, lines 28/29), and
- a fixed, acoustically transmissive counter-element (12) arranged above the membrane (11);
**wherein**
- the layer construction (20) comprises at least one enclosure layer (3) between the membrane (11) and the substrate (1), and
- an acoustically transparent aperture opening (4) is formed in said enclosure layer (3), the membrane (11) being connected to the rear-side volume (13) via said opening, and
- the rear-side volume (13) extends below the enclosure layer (3) laterally beyond said aperture opening (4),
**characterized**
**in that** a lateral undercut is situated below the edges of the enclosure layer (3) which define the aperture opening (4), through which undercut the rear-side volume (13) extends laterally beyond the active membrane area.

2. Component (10) according to Claim 1, **characterized in that** the substrate rear side (16) is undercut (page 6, lines 26 to 28, page 10, line 36 to page 11, line 4 and lines 12 to 15).

3. Component (10) according to Claim 1 or 2, **characterized in that** the membrane (11) is provided between counter-element (12) and aperture opening (4), wherein the membrane is electrically insulated from the counter-element and the enclosure layer (3) containing the aperture opening.

4. Component (10) according to any of the preceding claims, **characterized in that** a membrane suspension and/or bypass openings (14) are/is formed in the edge region of the membrane (11), and **in that** the acoustically transparent aperture opening (4) in the enclosure layer (3) extends only over the closed central region of the membrane (11).

5. Component (10) according to any of the preceding claims, **characterized in that** the acoustically transparent aperture opening (4) is formed as a continuous opening in the enclosure layer (3).

6. Component according to any of Claims 1 to 4, **characterized in that** the acoustically transparent aperture opening is formed as a grid or hole structure in the enclosure layer.

7. Component according to Claim 6, wherein the membrane functions as a deflectable electrode, the fixed, acoustically transmissive counter-element comprises at least one counter-electrode and provision is made of means for applying a charging voltage between the membrane and the counter-electrode, **characterized in that** the grid or hole structure in the enclosure layer functions as a compensation electrode, and **in that** provision is made of means for applying a compensation voltage between the counter-electrode and the compensation electrode.

8. Method for producing a component having a micromechanical microphone structure, in particular for producing a component (10) according to any of Claims 1 to 7, in which a membrane (11) and a fixed, acoustically transmissive counter-element (12) are realized in the layer construction (20) above a substrate (1),
**wherein**
- a front-side process is used to define the position, form and dimensions of an acoustically transparent aperture opening (4) in an enclosure layer (3) between the substrate surface and the membrane layer (7) and
- the membrane (11) and the counter-element (12) are formed in the layer construction (20) above the enclosure layer (3), and
- a cavity (13) is introduced into the rear side of the substrate (1) and is connected to the microphone structure by exposure of the aperture opening (4) in the enclosure layer (3),
**characterized in that**
the aperture opening (4) is undercut laterally below the edges of the enclosure layer (3) that define the aperture opening (4), with the result that the rear-side volume (13) extends laterally beyond the active membrane area.

9. Method according to Claim 8, **characterized in that** the substrate rear side (16) is undercut in order to introduce the cavity (13) (page 6, lines 26 to 28, page 10, line 36 to page 11, line 4 and lines 12 to 15).

10. Method according to Claim 8 or 9, in which
- at least one first electrically insulting sacrificial layer (2) is applied to the substrate surface and structured, wherein the position, geometry and dimensions of the aperture opening (4) in at least one enclosure layer (3) subsequently produced above the first sacrificial layer (2) are defined,
- the at least one enclosure layer (3) is produced on the structured first sacrificial layer (2),
- at least one second electrically insulating sacrificial layer (5) is applied on the enclosure layer (3) and structured,
- a membrane layer (7) that is electrically conductive at least in regions is produced above the second sacrificial layer (5) and structured,
- at least one third electrically insulating sacrificial layer (6) is applied above the membrane layer (7) and structured,
- a layer (8) that is electrically conductive at least in regions is produced above the third sacrificial layer (6) for the purpose of realizing the fixed counter-element (12),
- said conductive layer (8) is structured in a front-side trench process, wherein the third sacrificial layer (6) serves as a stop layer,
- a cavity (13) is introduced into the rear side of the substrate (1) for the purpose of realizing a rear-side volume, wherein the first sacrificial layer (2) in the edge region of the cavity (13) and the second sacrificial layer (5) in the region of the aperture opening (4) function as stop layers, and
- at least the second and third sacrificial layers (5, 6) are removed in the membrane region in order to expose the membrane (11) in the membrane layer (7) between the counter-element (12) in the conductive layer (8) and the aperture opening (4) in the enclosure layer (3).

11. Method according to Claim 8 or 9, in which
- at least one first electrically insulating sacrificial layer (2) is applied to the substrate surface,
- the at least one enclosure layer (3) is produced on the first sacrificial layer (2) and structured, wherein the aperture opening (4) is produced with a defined position, geometry and defined dimensions,
- at least one second electrically insulating sacrificial layer (5) is applied to the enclosure layer (3) and structured,
- a membrane layer (7) that is electrically conductive at least in regions is produced above the second sacrificial layer (5) and structured,
- at least one third electrically insulating sacrificial layer (6) is applied above the membrane layer (7) and structured,
- a layer (8) that is electrically conductive at least in regions is produced above the third sacrificial layer (8) for the purpose of realizing the fixed counter-element (12),
- said conductive layer (8) is structured in a front-side trench process, wherein the third sacrificial layer (6) serves as a stop layer,
- a cavity (13) is introduced into the rear side of the substrate (1) for the purpose of realizing a rear-side volume, wherein the first sacrificial layer (2) functions as an etching stop boundary,
- the first, second and third sacrificial layers (2, 5, 6) are removed in the membrane region and in the region of the aperture opening (4) in order to expose the membrane (11) in the membrane layer (7) between the counter-element (12) in the conductive layer (8) and the aperture opening (4) in the enclosure layer (3).

12. Method according to any of Claims 8 to 11, **characterized in that** the cavity is introduced into the rear side of the substrate by a combination of an anisotropic and a subsequent isotropic etching step.

13. Method according to any of Claims 8 to 12, **characterized in that** a silicon substrate is used as the substrate, **in that** the first sacrificial layer is formed from a thermal oxide or a TEOS oxide, and **in that** a polysilicon layer or an epitaxial polysilicon layer is used as the enclosure layer.

## Revendications

1. Élément de construction (10) muni d'une structure de microphone micromécanique qui est réalisée en une construction stratifiée (20) au-dessus d'un substrat (1), la structure de microphone comprenant au moins
- une membrane (11) pouvant être déviée par la pression acoustique, laquelle recouvre une caverne (13) dans le côté arrière du substrat (p. 5 lignes 28/29) qui fait office de volume de côté arrière, et
- un contre-élément (12) fixe perméable aux ondes acoustiques qui est disposé au-dessus de la membrane (11),
avec lequel
- la construction stratifiée (20) comprend au moins une couche d'enchâssement (3) entre la membrane (11) et le substrat (1), et
- une ouverture de diaphragme (4) transparente aux ondes acoustiques est formée dans cette couche d'enchâssement (3), par le biais de laquelle la membrane (11) est raccordée au volume de côté arrière (13), et
- le volume de côté arrière (13) s'étend sous la couche d'enchâssement (3) latéralement jusqu'au-dessus de cette ouverture de diaphragme (4),
**caractérisé en ce**
**qu'**une gravure sous-jacente latérale se trouve sous les bords de la couche d'enchâssement (3) qui définissent l'ouverture de diaphragme (4), à travers laquelle le volume de côté arrière (13) s'étend latéralement au-dessus de la surface de membrane active.

2. Élément de construction (10) selon la revendication 1, **caractérisé en ce que** le côté arrière du substrat (16) est gravé de manière sous-jacente (page 6, lignes 26 à 28, page 10, ligne 36 à page 11, ligne 4, ainsi que lignes 12 à 15).

3. Élément de construction (10) selon la revendication 1 ou 2, **caractérisé en ce que** la membrane (11) est prévue entre le contre-élément (12) et l'ouverture de diaphragme (4), la membrane étant électriquement isolée par rapport au contre-élément et à la couche d'enchâssement (3) contenant l'ouverture de diaphragme.

4. Élément de construction (10) selon l'une des revendications précédentes, **caractérisé en ce qu'**une suspension de membrane et/ou des ouvertures de diaphragme (14) sont formées dans la zone de bordure de la membrane (11) et **en ce que** l'ouverture de diaphragme (4) transparente aux ondes acoustiques dans la couche d'enchâssement (3) ne s'étend qu'au-dessus de la zone centrale fermée de la membrane (11).

5. Élément de construction (10) selon l'une des revendications précédentes, **caractérisé en ce que** l'ouverture de diaphragme (4) transparente aux ondes acoustiques est réalisée sous la forme d'une ouverture continue dans la couche d'enchâssement (3).

6. Élément de construction (10) selon l'une des revendications 1 à 4, **caractérisé en ce que** l'ouverture de diaphragme transparente aux ondes acoustiques est réalisée sous la forme d'une structure en grille ou perforée dans la couche d'enchâssement.

7. Élément de construction selon la revendication 6, avec lequel la membrane fait office d'électrode à déviation, le contre-élément fixe perméable aux ondes acoustiques comprend au moins une contre-électrode et des moyens sont prévus pour appliquer une tension de charge entre la membrane et la contre-électrode, **caractérisé en ce que** la structure en grille ou perforée dans la couche d'enchâssement fait office d'électrode de compensation et **en ce que** des moyens sont prévus pour appliquer une tension de compensation entre la contre-électrode et l'électrode de compensation.

8. Procédé de fabrication d'un élément de construction muni d'une structure de microphone micromécanique, notamment de fabrication d'un élément de construction (10) selon l'une des revendications 1 à 7, avec lequel une membrane (11) et un contre-élément (12) fixe perméable aux ondes acoustiques sont réalisés en une construction stratifiée (20) au-dessus d'un substrat (1),
avec lequel
- dans un processus de côté avant, la position, la forme et les dimensions d'une ouverture de diaphragme (4) transparente aux ondes acoustiques sont définies dans une couche d'enchâssement (3) entre la surface du substrat et la couche de membrane (7), et
- la membrane (11) et le contre-élément (12) sont formés au-dessus de la couche d'enchâssement (3) en construction stratifiée (20), et
- une caverne (13) est réalisée dans le côté arrière du substrat (1) et raccordée à la structure de microphone en libérant l'ouverture de diaphragme (4) dans la couche d'enchâssement (3),
**caractérisé en ce que**
l'ouverture de diaphragme (4) est gravée de manière sous-jacente latéralement sous les bords de la couche d'enchâssement (3) qui définissent l'ouverture de diaphragme (4), de sorte que le volume de côté arrière (13) s'étende latéralement au-dessus de la surface de membrane active.

9. Procédé selon la revendication 8, **caractérisé en ce que** pour réaliser la caverne (13), le côté arrière du substrat (16) est gravé de manière sous-jacente (page 6, lignes 26 à 28, page 10, ligne 36 à page 11, ligne 4, ainsi que lignes 12 à 15).

10. Procédé selon la revendication 8 ou 9, avec lequel
- au moins une première couche consommable (2) électriquement isolante est appliquée et structurée sur la surface du substrat, la position, la forme géométrique et les dimensions de l'ouverture de diaphragme (4) étant définies dans au moins une couche d'enchâssement (3) suivante générée au-dessus de la première couche consommable (2),
- l'au moins une couche d'enchâssement (3) est générée sur la première couche consommable (2) structurée,
- au moins une deuxième couche consommable (5) électriquement isolante est appliquée et structurée sur la couche d'enchâssement (3),
- une couche de membrane (7) électriquement conductrice au moins dans certaines zones est générée et structurée sur la deuxième couche consommable (5),
- au moins une troisième couche consommable (6) électriquement isolante est appliquée et structurée sur la couche de membrane (7),
- une couche (8) électriquement conductrice au moins dans certaines zones est générée sur la troisième couche consommable (6) pour réaliser le contre-élément (12) fixe,
- cette couche (8) conductrice est structurée dans un processus de creusement du côté avant, la troisième couche consommable (6) servant de couche d'arrêt,
- pour réaliser un volume de côté arrière, une caverne (13) est réalisée dans le côté arrière du substrat (1), la première couche consommable (2) faisant office de couche d'arrêt dans la zone du bord de la caverne (13) et la deuxième couche consommable (5) faisant office de couche d'arrêt dans la zone de l'ouverture de diaphragme (4), et
- au moins la deuxième et la troisième couches consommables (5, 6) sont enlevées dans la zone de la membrane afin de libérer la membrane (11) dans la couche de membrane (7) entre le contre-élément (12) dans la couche (8) conductrice et l'ouverture de diaphragme (4) dans la couche d'enchâssement (3).

11. Procédé selon la revendication 8 ou 9, avec lequel
- au moins une première couche consommable (2) électriquement isolante est appliquée sur la surface du substrat,
- au moins une couche d'enchâssement (3) est générée et structurée sur la première couche consommable (2), l'ouverture de diaphragme (4) étant générée avec une position, une forme géométrique et des dimensions définies,
- au moins une deuxième couche consommable (5) électriquement isolante est appliquée et structurée sur la couche d'enchâssement (3),
- une couche de membrane (7) électriquement conductrice au moins dans certaines zones est générée et structurée sur la deuxième couche consommable (5),
- au moins une troisième couche consommable (6) électriquement isolante est appliquée et structurée sur la couche de membrane (7),
- une couche (8) électriquement conductrice au moins dans certaines zones est générée sur la troisième couche consommable (6) pour réaliser le contre-élément (12) fixe,
- cette couche (8) conductrice est structurée dans un processus de creusement du côté avant, la troisième couche consommable (6) servant de couche d'arrêt,
- pour réaliser un volume de côté arrière, une caverne (13) est réalisée dans le côté arrière du substrat (1), la première couche consommable (2) faisant office de couche d'arrêt de gravure,
- la première, la deuxième et la troisième couches consommables (2, 5, 6) sont enlevées dans la zone de la membrane et dans la zone de l'ouverture de diaphragme (4) afin de libérer la membrane (11) dans la couche de membrane (7) entre le contre-élément (12) dans la couche (8) conductrice et l'ouverture de diaphragme (4) dans la couche d'enchâssement (3).

12. Procédé selon l'une des revendications 8 à 11, **caractérisé en ce que** la caverne est réalisée dans le côté arrière du substrat par combinaison d'une coupe de gravure anisotrope et d'une coupe de gravure isotrope suivante.

13. Procédé selon l'une des revendications 8 à 12, **caractérisé en ce que** le substrat utilisé est un substrat au silicium, **en ce que** la première couche consommable est formée d'un oxyde thermique ou d'un oxyde de tétraéthoxysilane et **en ce qu'**une couche de polysilicium ou une épi-couche de polysilicium est utilisée comme couche d'enchâssement
